# EUROPEAN PATENT APPLICATION

(11) **EP 2 484 584 A2**
(43) Date of publication of application: **08.08.2012**
(21) Application number: 10770536.0
(22) Date of filing: 28.09.2010
(51) Int. Cl.: B64C 1/06

(54) **AIRCRAFT FRAME AND METHOD FOR OBTAINING IT**

(30) Priority: 29.09.2009 ES 200930757
(71) Applicant: Airbus Operations S.L., 28906 Madrid (ES)
(72) Inventor: VERA VILLARES, Enrique, E-28903 Getafe Madrid (ES); PINA LÓPEZ, José María, E-28922 Alcorcón Madrid (ES)
(74) Representative: Elzaburu Marquez, Alberto
(86) International application number: PCT/ES2010/070628
(87) International publication number: WO 2011/039399

(57) **Abstract**

Aircraft frames and method for obtaining them, which frames are being made of composite material, and they comprise several partitions (20) that form, when joined, the aforementioned frame in its entirety, with these partitions (20) comprising sections (1) with a length (2), and sections (1) that are being arranged on the inside of the skin (3) that forms the fuselage of the aircraft. This fuselage is integrally embodied in a single piece, with the length (2) of the sections (1) being the maximum possible, in such a way that the maximum separation (5) between the frame section (1) and the skin (3), with said separation (5) being measured by the inside of the aforementioned skin (3), is lower than the limit value permitted for the use of sealant in liquid state.

## Description

### FIELD OF THE INVENTION

This invention refers to a new design of aircraft frames in a composite material, specifically for fuselages integrated into a single piece, as well as to a method for obtaining them.

### BACKGROUND OF THE INVENTION

The fuselage is the main assembly of an aircraft, given that the remaining elements that make up the aircraft are directly or indirectly joined to it. The skin of the fuselage is what gives it its shape, which varies with the main mission that the aircraft will have.

In addition to the skin (the one being considered is CFRP - Carbon Fiber Reinforced Plastic), the fuselage of an aircraft comprises some elements in the shape of perpendicular framework with respect to the lengthwise axis of the aircraft, called frames (made of CFRP or metal, in the shape of a C, Z, etc.), which are responsible for giving shape and rigidity to the fuselage structure, with these frames being located at given intervals on the inside of the aircraft fuselage. In addition to the frames, the fuselage comprises other reinforcement elements, such as the stringers (generally in an omega shape, T or similar) to achieve optimization of load distribution and rigidity. The stringers are located lengthwise on the fuselage skin, allowing the optimization of the same, thus lightening the weight of the combined structure. In this manner, the entire grid of frames, stringers and skin are joined together to form a complete structure.

Traditionally, the fuselage of an aircraft was built-up in a segmented way, so that the skin was formed by several panels and sections which were later joined to form the typical fuselage in a cylindrical shape. The joints between these segments or panels were embodied through a series of joining parts designed for this purpose, which generally were joined with fasteners . The frames in the case of these fuselages were adjusted manually on the previous structure. This procedure of arrangement and placing the frames is an easy assembly, since the parts that make up the fuselage skin are opened on the inside, in such a manner that it allows a simple and correct adjustment of the frames, by segments. However, this procedure forces a very high number of segments or partitions of the frames, which involves also having to use a large number of joining parts between the frames and the skin that make up the fuselage. This causes the procedure of assembling the frames to be very long and expensive, using a large amount of assembly labor.

Today, it is becoming increasingly common the manufacturing of the skin that makes up the fuselage of an aircraft to be obtain in one whole piece, called 360°, full-barrel or one-shot fuselage. The skin that forms the fuselage is formed integrally into a single closed piece from a single mould. With these integral skins, the segmenting of frames has to be approached differently from the segmenting used until now, as it's necessary to pay attention to the difference tolerances that are involved in the manufacturing and assembly processes and also to access limitations for the arrangement of these segmented frames.

The present invention offers a solution to the aforementioned limitations.

### SUMMARY OF THE INVENTION

Thus, according to a first aspect, this invention refers to a new design of aircraft frames made of composite material, those frames being made in partitions or segments with a determined length, which will be arranged on the interior of the skin that forms the aircraft fuselage. The fuselage will be integrally manufactured in a single piece (called full-barrel or one-shot fuselage). This fuselage may comprise integrated stringers from the same manufacturing process of the aforementioned fuselage. The length of the partitions or segments of the frames will be the maximum possible (which will lead to the minimum number of partitions per diameter of fuselage section), so that the maximum gap between these frame segments and the skin, with this gap being measured from the interior of the skin, allows the use of a liquid sealant for joining the frame segment to the skin. The use of this type of sealant simplifies the operations and decreases the assembly times, which allows recurring costs to decrease in this regard. The maximum length of the frame segments will be calculated based upon the manufacturing limitations given by the manufacturing tolerances of the skin and of the same frame segments.

Furthermore, in the design of the partitions or segments of these frames, the following considerations must be taken into account:
- contraction or spring-back effect during the manufacturing of the frame elements;
- assembly process of the frame partitions or segments;
- geometry of the fuselage section, given by the skin, where the frame partition or segment will be arranged;
- the loads to which the fuselage section is subject, given by the skin, where the frame partition or segment will be arranged.

According to a second aspect, the invention refers to a method for obtaining the design of aircraft frames, which are made of composite material, and comprising partitions or segments of a given length, in such a manner that the calculated frame segments maintain a maximum separation with respect to the interior of the skin, which is such that it will allow the use of a liquid sealant for joining the frame segment to the skin that forms the fuselage.

Thus, the method of the invention comprises the following stages:
a) determining a first frame type segment for the upper part of the fuselage skin, for a given section of the fuselage, with this being calculated for the case where the aerodynamic tolerance on the skin causes this to have a maximum effective external dimension, with the thickness tolerance of the skin being as low as possible, in such a way that the inside dimension of the skin is maximum and the manufacturing tolerance of this frame segment is minimal, which causes the dimension of the frame segment to be minimal;
b) determining the point of contact of the frame type segment with the inside of the skin as a result of stage a);
c) determining the frame segment points on both sides of the previous contact point, where the maximum separation between the frame segment and the inside of the skin is the maximum permitted for the use of a liquid type sealant;
d) calculating the length of the maximum frame segment as per stages a) to c) above, and such that the ends of the frame segment are arranged at halfway of a between two consecutive stringers of the section;
e) repeating stages a) to d) above for the remaining segments that will form the partitions of the frame in its entirety;
f) determining a second frame type segment for the upper part of the fuselage skin, for the aforementioned given section of the fuselage, with this being calculated for the case where the aerodynamic tolerance on the skin causes this to have a minimum effective external dimension, with the thickness tolerance of the skin being the maximum possible, in such a way that the inside dimension of the skin is minimal and the manufacturing tolerance of this frame segment is a maximum, which causes the dimension of the aforementioned frame segment to be the maximum;
g) determining the points of contact of the frame type segment with the inside of the skin as a result of stage f);
h) determining the frame segment point on which the maximum separation between the frame segment and the inside of the skin is the maximum permitted for the use of a liquid type sealant;
i) calculating the length of the maximum frame segment as per stages f) to h) above, and such that the ends of the frame segment are arranged at halfway of a span between two consecutive stringers of the section;
j) repeating stages f) to i) above for the remaining segments that will form the partitions of the frame in its entirety;
k) determining the definitive frame segments, such that said segments verify both stages a) to d) and stages f) to j) as cited above, with the segments forming the definitive partitions of the entirety of the frames, for the specific calculated fuselage section;
l) determining the fuselage frame segments for each specific fuselage section, following stages a) to k) above.

Other characteristics and advantages of this invention will come from the detailed description that follows of an embodiment illustrating its purpose in relation to the attached figures.

### DESCRIPTION OF THE FIGURES

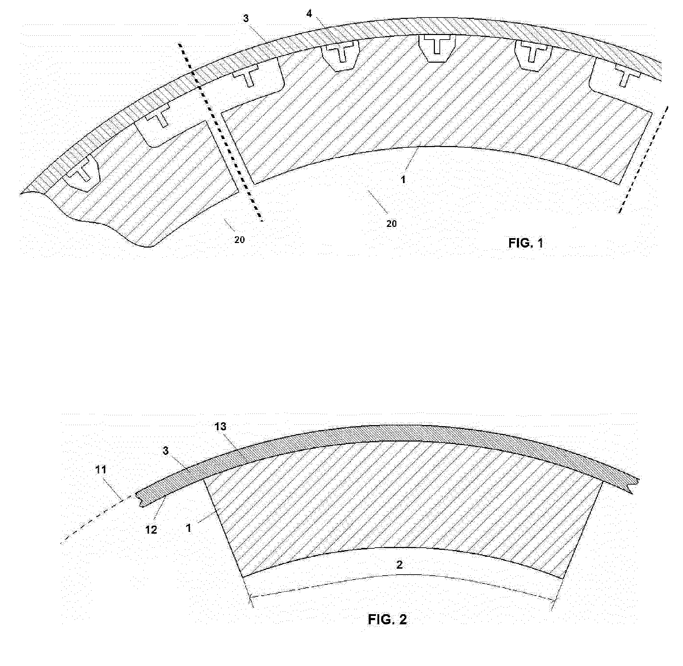

Figure 1 shows in a section a breakdown of an aircraft fuselage that comprises an aircraft fuselage design as per this invention.
Figure 2 shows in a section the tolerances that are taken into consideration for the design of the aircraft frames as per this invention.
Figure 3 shows in a section the case where the manufacturing tolerances that are taken into consideration for the design of the aircraft frame as per the method of this invention, converge so that the manufactured frame is at its smaller size than its nominal value, with the fuselage skin being manufactured at its larger size and lower thickness than its respective nominal values.
Figure 4 shows in a section the case where the manufacturing tolerances that are taken into consideration for the design of the aircraft frame as per the method of this invention, converge so that the manufactured frame is a larger size than its nominal value, with the fuselage skin being manufactured in a smaller size and greater thickness than its respective nominal values.

### DETAILED DESCRIPTION OF THE INVENTION

Thus, this invention refers to the new design of aircraft frames made of composite material, which are being made in partitions or segments 1 with a determined length 2, which will be arranged on the interior of the skin 3 that forms the aircraft fuselage. The fuselage will be manufactured in a single piece (called full-barrel or one-shot fuselage), so that the length 2 of the partitions or segments 1 of the aforementioned frames will be the maximum possible (which will lead to the minimum number of partitions 1 per diameter of fuselage section), so that the maximum gap 5 between each frame section 1 and the skin 3, with this distance or gap 5 being measured by the interior of the fuselage, is lower than the permitted limit for the application of a liquid sealant. This maximum gap 5 will be calculated based upon the manufacturing limitations given by the manufacturing tolerances of skin 3 and of the frames. Typically, the value of maximum gap 5 for the application of a liquid sealant is around 0.5 mm. Another type of sealant must be applied when above this separation value 5 (typically solid sealant), which increases the assembly times and decreases the mechanical properties of the assembly.

Furthermore, the design of the partitions 20 in segments 1 of the aforementioned frames, as per the invention, is also determined on the basis of:
- contraction or spring-back effect of sections 1 of the frame during the manufacturing of the frame sections 1;
- assembly process of the frame sections 1 in its partitions 20, taking into consideration that the access for this assembly process is limited, since the skin of the fuselage is manufactured integrally in one part (full-barrel or one-shot);
- geometry of the fuselage section where section 1 of the frame is arranged, specifically the curvature of the same;
- the loads to which the fuselage section is subject, where section 1 of the frame is arranged, avoiding where possible embodying the partition or section 1 of the frame in an area or section of fuselage that is subject to a very high load.

In this manner, and based upon the foregoing, the length 2 of the frame section 1 will be such that the lowest possible number of sections 1 or partitions 20 will be obtained, i.e. the length 2 will be the highest possible. In this manner savings are achieved in the number of joining parts and elements used in the traditional designs, as well as in assembly time, by avoiding the use of sealants in a solid state, which leads to savings in assembly time and labor, thus avoiding problems in the riveting operation, without this involving a loss of mechanical characteristics of the joint.

Taking into consideration the manufacturing tolerances of skin 3 (aerodynamic tolerance that causes skin 3 to have an effective external value of 11 and thickness tolerance of the skin 3 that causes the skin 3 to have an effective internal value of 12) and of frame section 1 (manufacturing tolerance of frame section 1, which causes the aforementioned frame to have an effective external value of 13), as well as the limitations imposed by the maximum admissible gap 5 in assembly under which it is possible to apply liquid sealant, the number and optimal position of frame sections 1 of the invention are defined, i.e. the number of partitions 20 of which the complete frame of the invention is composed.

Two extreme cases are considered for the calculation of the maximum length 2 of the partitions or segments 1 of the aforementioned frames, which will determine the number of partitions 20 of which the frame is composed in its entirety, based upon the calculation of the maximum gap 5. This is embodied by taking into consideration the manufacturing limitations given by the manufacturing tolerances of skin 3 (aerodynamic tolerance that causes skin 3 to have an effective external value of 11 and thickness tolerance of the skin 3 that causes the skin 3 to have an effective internal value of 12) and of frame section 1 (manufacturing tolerance of frame section 1, which causes the aforementioned frame to have an effective external value of 13).

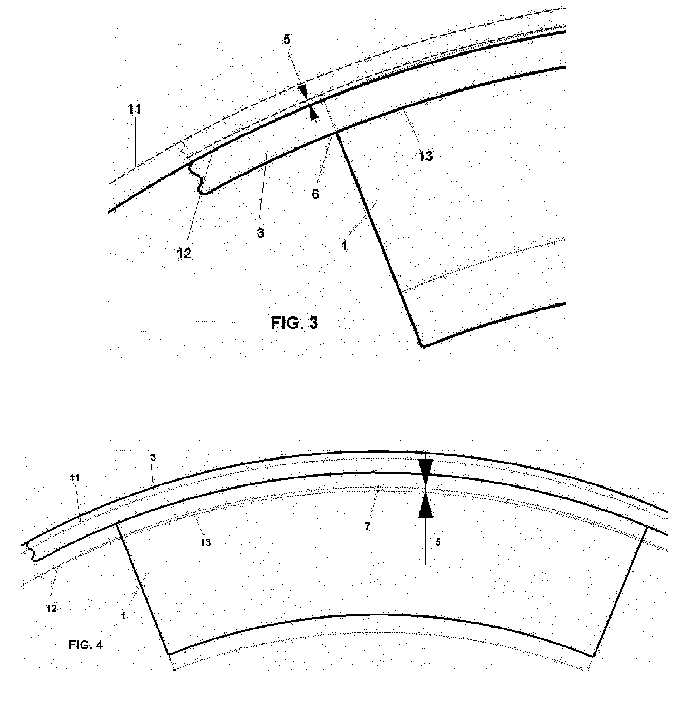

### Case 1 (Figure 3):

- skin 3 is at its maximum size, since the aerodynamic tolerance is at its maximum (effective external value 11 is the maximum) and its thickness tolerance at its minimum (effective internal value 12 is the maximum);
- frame section 1 is at its minimum size, since the manufacturing tolerance of the same is the minimum (effective external value 13 is the minimum);
- under the above conditions, the maximum gap 5 between the skin 3 and frame section 1, for the of cylindrical fuselage, appears close to the ends 6 of the frame section 1 (Figure 3).

### Case 2 (Figure 4):

- skin 3 is at its minimum size, since the aerodynamic tolerance of the same is at its minimum (effective external value 11 is the minimum) and its thickness tolerance the maximum (effective internal value 12 is the minimum);
- frame section 1 is a maximum size, since the manufacturing tolerance of the same is the maximum (effective external value 13 is the maximum);
- under the above conditions, the maximum gap 5 between the skin 3 and frame section 1, for the of cylindrical fuselage, appears in an area 7 close to the center of the frame section 1 (Figure 4).

Thus, based upon cases 1 and 2 mentioned above, the maximum gap 5 is systematically obtained for each possible frame section 1, as per the invention. Once the areas are known in which the gap between skin 3 and the frame segments 1 is the maximum and lower than the application limit of the defined liquid sealant, and in accordance with the remaining consideration, the frame partitions 20 are defined between two consecutive stringers 4, independently of the fact that the 4 are already integrated from the same manufacturing process of the aforementioned fuselage, or manufactured independently and then arranged on the aircraft fuselage, generally through rivets.

According to a second aspect, the invention develops a method for obtaining these aircraft frames made of composite material, with those frames being embodied in partitions or segments 1 of a given length 2, which will be arranged on the inside of skin 3 that forms the aircraft fuselage. Thus, the method of the invention comprises the following stages:
a) determining a first frame type segment 1 for the upper part of the fuselage skin 3, for a given section of the fuselage, with this first segment 1 being calculated for the case where the aerodynamic tolerance on the skin causes this to have a maximum effective external dimension 11, with the thickness tolerance of the skin being as low as possible, in such a way that the inside dimension of the skin 12 is maximum and the manufacturing tolerance of this frame type segment is minimal, which causes the dimension 13 of the aforementioned frame segment 1 to be minimal;
b) determining the point of contact of the frame type segment 1 with the inside of the skin 3 as a result of stage a);
c) determining the frame segment 1 points on both or the previous contact point, where the maximum gap 5 between said frame segment 1 and the inside of the skin 3 is the maximum permitted for the use of a liquid type sealant;
d) calculating the length 2 of the maximum frame segment 1 as per stages a) to c) above, and such that the ends of the frame segment 1 are arranged at halfway of a span between two consecutive 4 of the section;
e) repeating stages a) to d) above for the remaining segments 1 that will form the partitions of the frame in its entirety;
f) determining a second frame type segment 1 for the upper part of the fuselage skin 3, for the aforementioned given section of the fuselage, with said second segment 1 being calculated for the case where the aerodynamic tolerance on the skin causes this to have a minimum effective external dimension 11, with the thickness tolerance of the skin being the maximum possible, in such a way that the inside dimension of the skin 12 is minimal and the manufacturing tolerance of this frame segment is a maximum, which causes the dimension 13 of the aforementioned frame segment 1 to be the maximum;
g) determining the points of contact of the frame type segment 1 with the inside of the skin 3 as a result of stage f);
h) determining the frame segment point 1 on which the maximum separation between said frame segment and the inside of the skin 3 is the maximum permitted for the use of a liquid type sealant;
i) calculating the length 2 of the maximum frame segment 1 as per stages f) to h) above, and such that the ends of the frame segment 1 are arranged at halfway of a span between two consecutive 4 of the section;
j) repeating stages f) to i) above for the remaining segments 1 that will form the partitions of the frame in its entirety;
k) determining the definitive frame segments 1, such that said segments 1 verify both stages a) to d) and stages f) to j) as cited above, with the segments 1 forming the definitive partitions of the entirety of the frames, for the specific calculated fuselage section;
l) determining the fuselage frame segments 1 for each specific fuselage section, following stages a) to k) above.

For the best and fastest attainment of the method described above, it is desirable to prepare tabulations to which one may turn for carrying out the stages d), e), i), j) and k) above. It is also possible to carry out stages d), e), i), j) and k) above through any computer calculation program.

The aircraft fuselage, and therefore the skin that forms the same can have a cylindrical section, or a conical section. In addition, they can have certain section changes throughout their length, according to the lengthwise axis of the aircraft. In any of these cases, the method of the invention and the design of frames obtained with the same, are perfectly valid.

In the case where the fuselage, and therefore the skin 3 is cylindrical, in the above stage c), the points on which it occurs that the maximum gap 5 between the skin 3 and frame segment 1 is such that it allows the use of liquid type sealant, are found on ends 6 of the calculated frame segment 1. For the case of stage h) above, the point on which the maximum gap 5 between the skin 3 and the frame section 1 appears, is found in an area 7 close to the center of the frame section 1.

In the preferred embodiments that we have just described, those modifications can be introduced that are included within the scope defined by the following claims.

## Claims

1. Aircraft frames made of composite material, which are comprising several partitions (20) that form, when joined, the aforementioned frame in its entirety, with said partitions (20) comprising sections (1) with a length (2), and said sections (1) being arranged on the inside of the skin (3) that forms the fuselage of the aircraft. This fuselage is integrally embodied in a single piece, **characterized in that** the length (2) of the sections (1) is the maximum possible, in such a way that the maximum separation (5) between the frame section (1) and the skin (3), with said separation (5) being measured by the inside of the aforementioned skin (3), is lower than the limit value permitted for the use of sealant in liquid state.

2. Aircraft frame as per claim 1, **characterized in that** the maximum separation (5) is calculated by taking into consideration the manufacturing limitations given by the manufacturing tolerances of the skin (3) and the frame section (1).

3. Aircraft frame as per claim 2, **characterized in that** the manufacturing tolerances of the skin (3) are taken into consideration (aerodynamic tolerance that skin (3) to have an effective external value of (11) and thickness tolerance of the skin (3) that causes the skin (3) to have an effective internal value of (12)) and of frame section (1) (manufacturing tolerance of frame section (1), which causes the aforementioned frame to have an effective external value of (13)), for the calculation of the maximum separation (5).

4. Aircraft frame as per any of the above claims, **characterized in that** the coverage (3) of the fuselage comprises stringers (4) integrated from the manufacturing process of the aforementioned skin (3).

5. Aircraft frame as per any of the above claims, **characterized in that** the partitions (20) of the frame are not embodied in areas where the fuselage is subject to a high load.

6. Aircraft frame as per any of the above claims, **characterized in that** the maximum separation (5) between the frame section (1) and the skin (3) is lower than the liquid sealant application limit.

7. Aircraft that comprises a frame as per any of the claims 1 to 6.

8. Method for obtaining an aircraft frame made of composite material, as per any of the claims 1 to 6, **characterized in that** it comprises the following stages:
a) determining a first frame type segment (1) for the upper part of the fuselage skin (3), for a given section of the fuselage, with this first segment (1) being calculated for the case where the aerodynamic tolerance on the skin this to have a maximum effective external dimension (11), with the thickness tolerance of the skin being as low as possible, in such a way that the inside dimension of the skin (12) is maximum and the manufacturing tolerance of this frame type segment is minimal, which causes the dimension (13) of the aforementioned frame segment (1) to be minimal;
b) determining the point of contact of the frame type segment (1) with the inside of the skin (3) as a result of stage a);
c) determining the frame segment (1) points on both sides of the previous contact point, where the maximum separation (5) between said frame segment (1) and the inside of the skin (3) is the maximum permitted for the use of a liquid type sealant;
d) calculating the length (2) of the maximum frame segment (1) as per stages a) to c) above, and such that the ends of the frame segment (1) are arranged at halfway of a span between two consecutive (4) of the section;
e) repeating stages a) to d) above for the remaining segments (1) that will form the partitions of the frame in its entirety;
f) determining a second frame type segment (1) for the upper part of the fuselage skin (3), for the aforementioned given section of the fuselage, with said second segment (1) being calculated for the case where the aerodynamic tolerance on the skin causes this to have a minimum effective external dimension (11), with the thickness tolerance of the skin being the maximum possible, in such a way that the inside dimension of the skin (12) is minimal and the manufacturing tolerance of this frame segment is a maximum, which causes the dimension (13) of the aforementioned frame segment (1) to be the maximum;
g) determining the points of contact of the frame type segment (1) with the inside of the skin (3) as a result of stage f);
h) determining the frame segment point (1) on which the maximum separation between said frame segment and the inside of the skin (3) is the maximum permitted for the use of a liquid type sealant;
i) calculating the length (2) of the maximum frame segment (1) as per stages f) to h) above, and such that the ends of the frame segment (1) are arranged at halfway of a span between two consecutive (4) of the section;
j) repeating stages f) to i) above for the remaining segments (1) that will form the partitions of the frame in its entirety;
k) determining the definitive frame segments (1), such that said segments (1) verify both stages a) to d) and stages f) to j) as cited above, with the segments (1) forming the definitive partitions of the entirety of the frames, for the specific calculated fuselage section;
l) determining the fuselage frame segments (1) for each specific fuselage section, following stages a) to k) above.
